Europäisches Patentamt

European Patent Office

Office européen des brevets

(11) Publication number: **0 135 117**
A2

## EUROPEAN PATENT APPLICATION

(21) Application number: **84109455.0**

(22) Date of filing: **08.08.84**

(51) Int. Cl.4: **H 05 K 13/02**

(30) Priority: **08.08.83 US 520972**

(43) Date of publication of application:
**27.03.85 Bulletin 85/13**

(84) Designated Contracting States:
**DE FR GB NL**

(71) Applicant: **TEKTRONIX, INC.**
**Tektronix Industrial Park D/S Y3-121 4900 S.W. Griffith Drive P.O. Box 500**
**Beaverton Oregon 97077(US)**

(72) Inventor: **Soeller, Richard**
**25 S.W. 144th Avenue**
**Beaverton Oregon 970005(US)**

(74) Representative: **Weickmann, Heinrich, Dipl.-Ing. et al,**
**Patentanwälte Dipl.-Ing. H.Weickmann Dipl.-Phys.Dr. K.Fincke Dipl.-Ing. F.A.Weickmann Dipl.-Chem. B. Huber Dr.-Ing. H. Liska Dipl.-Phys.Dr. J. Prechtel Möhlstrasse 22 D-8000 München 80(DE)**

(54) Object transporter apparatus.

(57) A printed circuit board processing system 20 including an object transporter apparatus for automatically transferring printed circuit boards between automatic component insertion machines. The system includes a transporter 36 for conveying the boards between insertion machines, an object loader 30 for loading boards onto the transporter, a plurality of processing stations 24 and 26 each operable for removing boards from the transporter for component insertion and for replacing the boards onto the transporter, an object unloader 42 for unloading boards from the end of the transporter, and a system controller 40 coupled to each processing station for controlling the flow of boards throughout the system. Each processing station includes a conveyor 44, a board depositor handler 46, a buffer storage unit 48, a fixture 50, an insertion machine 52, an elevator 54, and a board retriever handler 58. The conveyor transports boards between adjacent processing stations. The board depostio. handler of each processing station is instructed by the system controller to off-load boards from the transporter when the boards are scheduled for component insertion by that station. The buffer storage unit provides temporary storage for a stack of boards and selectively releases boards from the bottom of the stack to the fixture. Boards are positioned within the insertion machine by the fixture. After component insertion has been completed on a board, it is replaced on the transporter by the elevator and board retriever handler for transport to other downstream processing stations.

EP 0 135 117 A2

FIG. I

## BACKGROUND OF THE INVENTION

The present invention relates generally to apparatus for transporting uniform planar objects, and relates more particularly to an apparatus for automatically transporting printed circuit boards to and from automatic insertion machines for the automated insertion of electronic components.

Low cost mass production of printed circuit boards has been made possible through the use of automatic insertion machines for rapidly and automatically inserting components onto printed circuit boards prior to soldering. Automatic component insertion reduces production costs by reducing labor costs while improving product quality and reliability. Automatic insertion machines with component insertion rates in excess of 10,000 components per hour are currently in use. Since individual automatic insertion machines are typically capable of inserting only a limited range of component types, several such machines are needed to insert all of the components on one board. An automatic assembly system, for example, may have one insertion machine for inserting dual-in-line packaged (DIP) integrated circuits, another for inserting axial lead components such as resistors and capacitors, and a third for inserting connectors and pins.

To effectively utilize the high component insertion rates of automatic insertion machines, efficient printed circuit board handling is needed. Such handling involves loading printed circuit boards into and unloading from individual insertion machines and transfering printed circuit boards between machines. One handling system, built by Universal Instruments Corporation, was described in the May 1980 issue of _Assembly Engineering_ magazine on pages 22-26. The Universal handling system

utilized a batch handling technique wherein printed circuit boards were loaded into an insertion machine from a magazine of printed circuit boards and unloaded into another magazine upon completion of the insertion operation. Printed circuit boards were transferred between insertion machines by transferring magazines loaded with several printed circuit boards.

Several disadvantages were inherent in batch handling systems. First, printed circuit boards were processed in batches of several boards, rather than individually. Batch processing increases the number of semi-assembled boards within the assembly system, and therefore increases the cost of inventory. Second, magazines filled with printed circuit boards were heavy and difficult to transfer. Third, since different types of printed circuit boards required different components, not all printed circuit boards needed to be processed by each of the insertion machines. Thus to schedule a mix of board types to efficiently utilize the variable component insertion rates of several insertion machines, multiple magazines containing small numbers of the same board type were needed.

It would be desirable, therefore, to provide a printed circuit board handling system that is capable of efficiently transferring printed circuit boards between insertion machines by routing individual printed circuit boards according to the number and mix of components to be installed. It is also desirable to reduce the number of semi-assembled boards within the board handling system. Additionally, it would be desirable to dynamically reroute printed circuit boards to bypass component insertion machines that are offline for maintenance.

## SUMMARY OF THE INVENTION

In accordance with the illustrated preferred embodiment, the present invention automatically transfers planar and uniformly sized objects, such as printed circuit boards, between a plurality of processing means, such as automatic component insertion machines. The present invention is a processing system that includes transporter means for unidirectionally conveying the objects between an entrance area and an exit area, object loading means for loading objects onto the entrance area of the transporter means, a plurality of processing stations each operable for removing objects from the transporter means for processing by its associated processing means and for replacing the objects onto the transporter means after processing operations have been performed, object unloading means for unloading processed objects from the exit area of the transporter means, and control means coupled to each processing station for controlling the flow of objects through the processing system.

The transporter means is composed of several conveyors, each associated with one processing station. The conveyors are arranged end-to-end so that adjacent conveyors can exchange objects to transport the objects between processing stations. Each conveyor is positioned above its associated processing station and has two spaced apart belts for conveying the obhects. Drive means for each conveyor intermittently drives the belts by a predetermined distance to transport the objects.

Objects are loaded onto the entrance region of the transporter means by the object loading means. Objects are transported by the several conveyors to each of the processing stations and to the exit region of the transporter means. Each processing station is instructed by the control means to unload objects from its conveyor if the objects are scheduled for processing by the associated processing means. After the processing operations have been completed on an object, it is replaced on the transporter means for transport to other downstream processing stations. After objects have passed the last processing station, they are unloaded from the transporter means by the object unloading means.

Each processing station includes the conveyor, a board depositer handler, a buffer storage unit, a fixture, processing means, an elevator, and a board retriever handler. As described above, the conveyor transports objects between adjacent processing stations. The board depositer handler provides first handler means for off-loading, from the conveyor, objects to be processed by the processing means of the processing station. The buffer storage unit provides buffer storage means for receiving objects from the board depositer handler, stacking them in a stack, and selectively releasing objects from the bottom of the stack. Objects are received from the buffer storage unit and positioned within the processing means by the fixture. After the processing operations for an object have been completed, the fixture moves the object to a fixture unload position where the elevator raises the object to a staging position just below the conveyor. The board retriever handler provides second handler means for transferring objects from the staging position to the conveyor.

Both the board depositor handler and the board retriever handler are similar in design and function. Each handler includes support means for supporting it above the conveyor, moveable plate means for travel between an upper and a lower position, object grasping means for grasping, tilting, and releasing an object, and first actuator means for moving the moveable plate means between the upper and lower positions. The board depositor handler transfers an object from the conveyor to the buffer storage unit by first grasping and lifting the object from the belts of the conveyor, then tilting the object and lowering it through an open area between the belts, then leveling and releasing the object directly above the buffer storage unit. In a similar fashion, the board retriever handler transfers an object from the staging position to the conveyor by first grasping and tilting the object, then lifting the object through the open area between the belts, then leveling and lowering the object onto the belts, then releasing the object. In the preferred embodiment, the motive forces for the handlers are provided by pneumatic cylinders.

Temporary storage of objects within a processing station is provided by the buffer storage unit. Objects enter the buffer storage unit from the above positioned board depositor handler and exit the buffer storage unit to the fixture positioned below. Within the buffer storage unit, objects are spaced apart in a vertical stack. The buffer storage unit includes a frame, a plurality of roller means, and release means. Each roller means has two horizontally disposed and parallel axles that are interconnected for counterroation. Star wheels, with uniformly spaced apart spokes radiating therefrom, are affixed to the axles. The axles and star wheels of the roller means are positioned such that the spokes contact two opposite edges of an object. The roller means supports an object when its axles are constrained not to rotate, while permitting the object to drop when its axles are free to rotate. All roller means are oriented so that they form two vertical and parallel banks of star wheels. An object entering the top of the buffer storage unit drops until it encounters a roller means that can not rotate. The release means selectively constrains the rotation of the bottom-most roller means. The presence of an object in the buffer storage unit prevents rotation of the immediately above roller means, thus spacing apart objects in the stack.

## DESCRIPTION OF THE DRAWINGS

Figure 1 is a front elevation view of an object transporter apparatus, according to the present invention, for transporting objects such as printed circuit boards to and from automatic processing stations.

Figure 2 is a perspective view of one processing station and its associated transporter, board handlers, buffer storage device.

Figure 3 is a schematic diagram in block format of a control system utilized by the object transporter apparatus of Figure 1.

Figure 4 is a perspective view of a transporter utilized by the processing station of Figure 2.

Figure 5 is a perspective view of a board handler utilized by the processing station of Figure 2 to remove and replace printed circuit boards from and upon the transporter of Figure 4.

Figures 6a through 6e are five side elevation views, in sequential order, of the operation of the board handler of Figure 5.

Figures 7a and 7b are front elevation views of the operation of a board handler in releasing a printed circuit board.

Figure 8 is a perspective view of an alternative embodiment of a board handler.

Figures 9a through 9e are five side elevation views, in sequential order, of the operation of the board handler of Figure 8.

Figure 10 is a perspective view of a buffer storage device utilized by the processing station of Figure 2 for the temporary storage of printed circuit boards.

Figure 11 is an exploded perspective view of a release mechanism utilized by the buffer storage device of Figure 10.

Figures 12a and 12b are sectional views of the release mechanism of Figure 11.

Figure 13 is a side elevation view of the buffer storage device of Figure 10.

Figure 14 is a side elevation view, partially in section, of the operation of clamping cams utilized in a fixture in the processing station of Figure 2.

Figure 15 is a top plan view of the processing station of Figure 2 illustrating actuation of the clamping cams of Figure 14.

DESCRIPTION OF THE PREFERRED EMBODIMENT

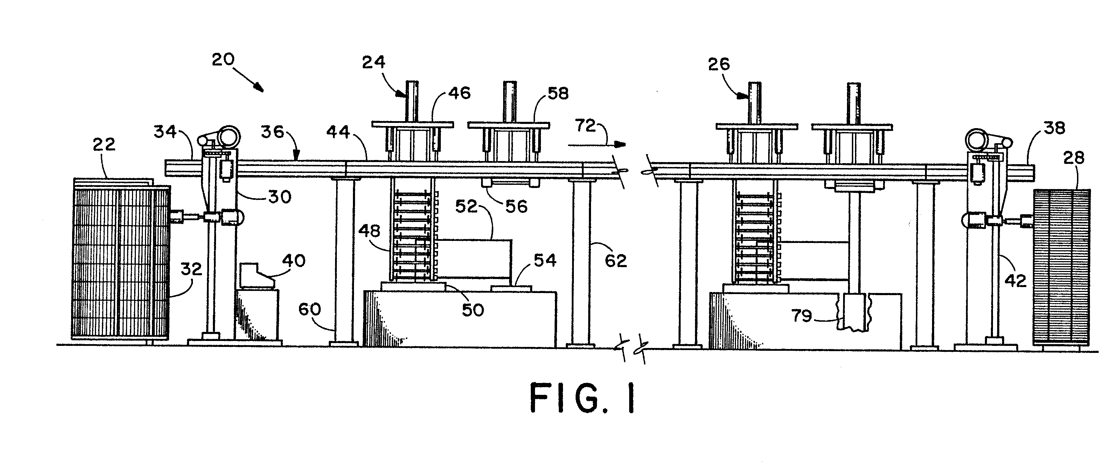

In reference now to Figure 1, there is shown a printed circuit board processing system 20 according to the present invention. Processing system 20 operates to transfer printed circuit boards from an input carrousel 22 to one or several processing stations 24 and 26 for the automatic insertion of components, and then to an output carrousel 28. Accordingly, an object loader 30 provides object loading means for withdrawing printed circuit boards 32 from the input carrousel 22 and for placing them upon an entrance region 34 of a transporter 36. Transporer 36 provides transporter means for transporting the printed circuit boards between processing stations and to an exit region 38 at the downstream end of the transporter. As printed circuit boards proceed down the transporter, the processing stations read identifying labels on the printed circuit boards. A system controller 40 provides control means to direct each processing station to off-load a printed circuit board if it is scheduled to have components inserted by that processing station. After components have been inserted, the printed circuit board is replaced onto the transporter for transport to other downstream processing stations. By the time the printed circuit board reaches the exit region 38, all automatically inserted components have been installed by the several processing stations. At the exit region, an object unloader 42 provides object unloading means for transferring printed circuit boards from the transporter to the output carrousel 28. Alternatively, transporter 36 could transfer the printed circuit boards directly to a conveyor feeding an automatic soldering machine or to a manual component insertion assembly operation.

Each of the one or several processing stations 24 and 26 in processing system 20 is operable for automatically inserting components into printed circuit boards. A typical processing system might include one processing station for installing dual-in-line packages, another for installing axial lead components, and a third for installing pins and connectors. While two processing stations 24 and 26 are illustrated in Figure 1, it is understood that any number of processing stations could be utilized. Production requirements may dictate, for example, that three axial lead insertion machines be used in combination with two dual-in-line package insertion machines and two pin and one connector insertion machines. It is also understood that the present invention relates to an apparatus and a method for transporting planar and uniformly sized objects between processing means in general, and that objects other than printed circuit boards and processing means other than automatic component insertion are encompassed by the scope of the invention.

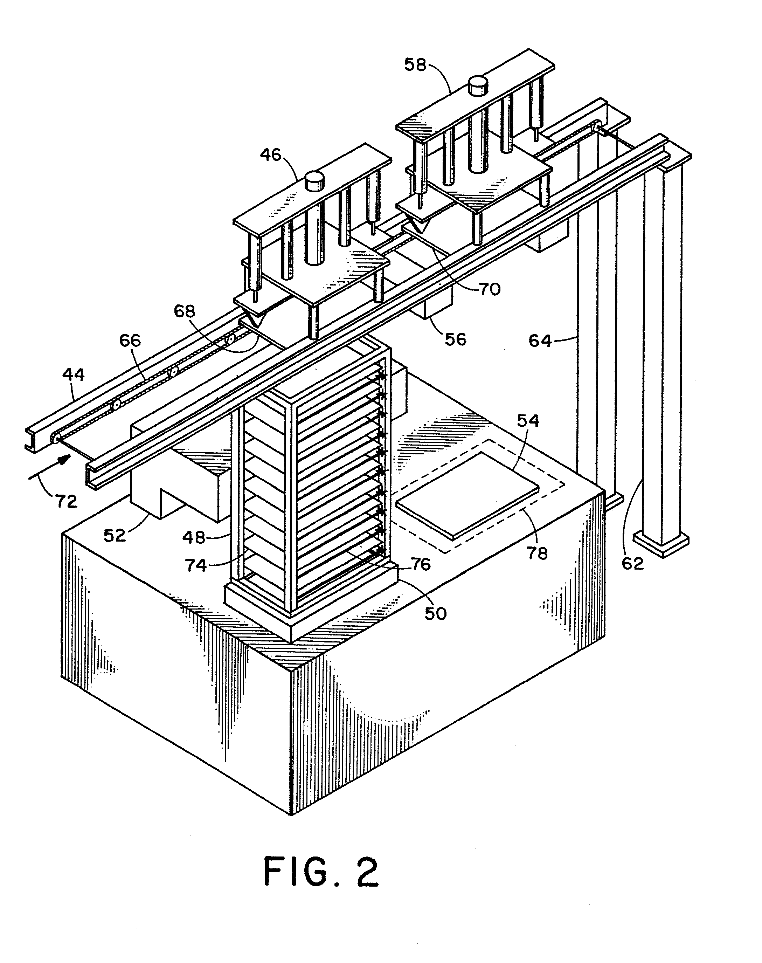

Each processing station includes a conveyor 44, a board depositor handler 46, a buffer storage unit 48, a fixture 50, an automatic component insertion machine 52, an elevator 54, a staging position 56, and a board retriever handler 58. The processing station is illustrated in both Figures 1 and 2. Conveyor 44 is supported at each end thereof by support columns 60, 62, and 64, and is positioned in line with other such conveyors to form the transporter 36. Motor driven belts 66 provide the means for transporting the printed circuit boards 68 and 70 along the direction of travel 72.

Board depositer handler 46 provides first handler means for off-loading, from the conveyor, printed circuit boards to be processed by insertion machine 52. To off-load a printed circuit board, the board depositer handler first grasps a printed circuit board 68 positioned on the conveyor below, then lifts and tilts the printed circuit board, then lowers it through an open area between the belts 66 of the conveyor, and then levels the printed ciruit board and releases it at a position directly above the buffer storage unit 48.

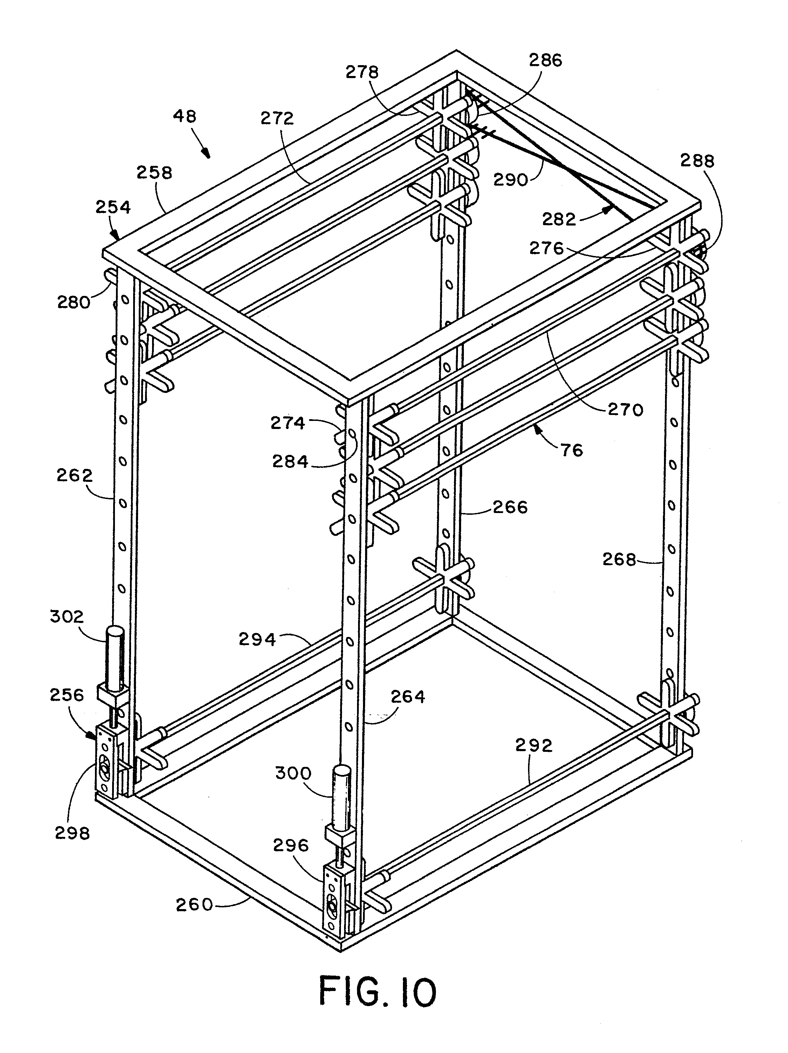

Buffer storage unit 48 provides buffer storage means for the temporary storage of a stack 74 of printed circuit boards. The buffer storage unit insures an adequate supply of printed circuit boards to feed into the insertion machine 52. Printed circuit boards are released by the board depositer handler 46 directly above the open top of the buffer storage unit. Several roller assemblies 76 guide the descent of a printed circuit board. The roller assemblies also operate to space apart the printed circuit boards in the stack. Printed circuit boards from the bottom of the stack are released to the fixture 50 when the insertion machine is ready to begin inserting components into another printed circuit board. The design an operation of the buffer storage unit will be described in greater detail below in conjunction with Figures 10-13.

Fixture 50 provides fixture means for receiving a printed circuit board released by the buffer storage unit, for positioning the board within the insertion machine 52 during component insertion, and for transferring the board to the elevator 54 when component insertion is completed. The fixture is capable of moving in two directions in the plane of the insertion machine, with its movements controlled by the insertion machine. When component insertion is completed, the fixture positions the printed circuit board at a fixture unload position 78, where it is lifted by the elevator up to the staging position 56. Vertical propulsion for the elevator is provided by a pneumatic cylinder 79 located within the base of the insertion machine. The staging position includes means for retaining the printed circuit board until the board retriever handler 58 replaces it onto the conveyor 44.

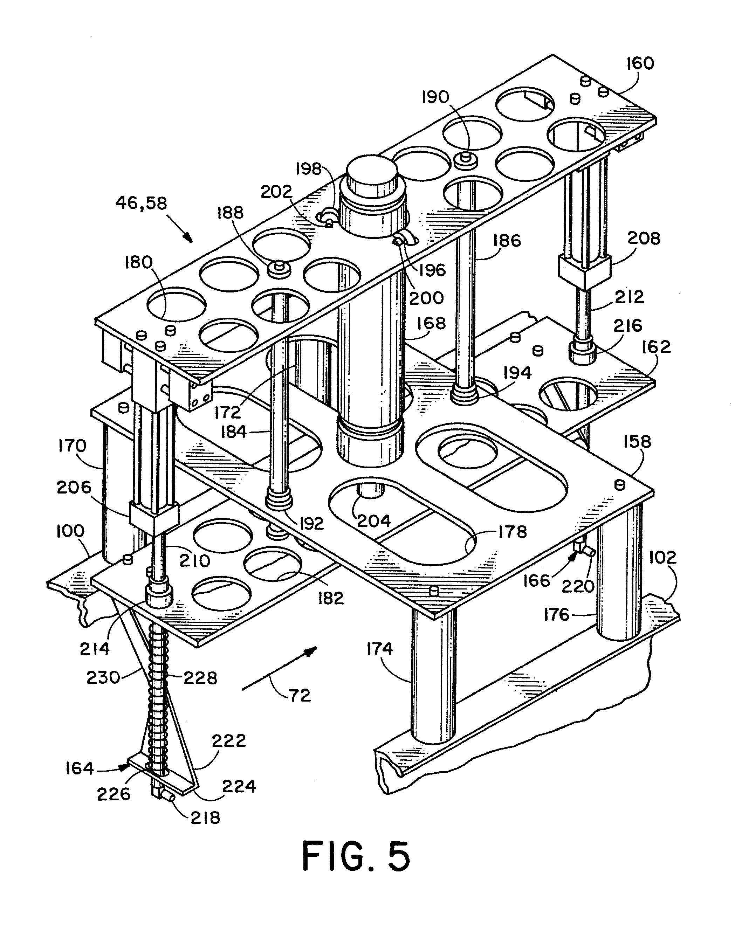

The board retriever handler 58 provides second handler means for transferring printed circuit boards from the staging position 56 to the conveyor 44. To do so, the board retriever handler first grasps and tilts the printed circuit board, then lifts it through the open area between the belts, then levels and lowers it onto the belts and releases it. The design and operation of the two board handlers will be described below in greater detail with reference to Figures 5-9.

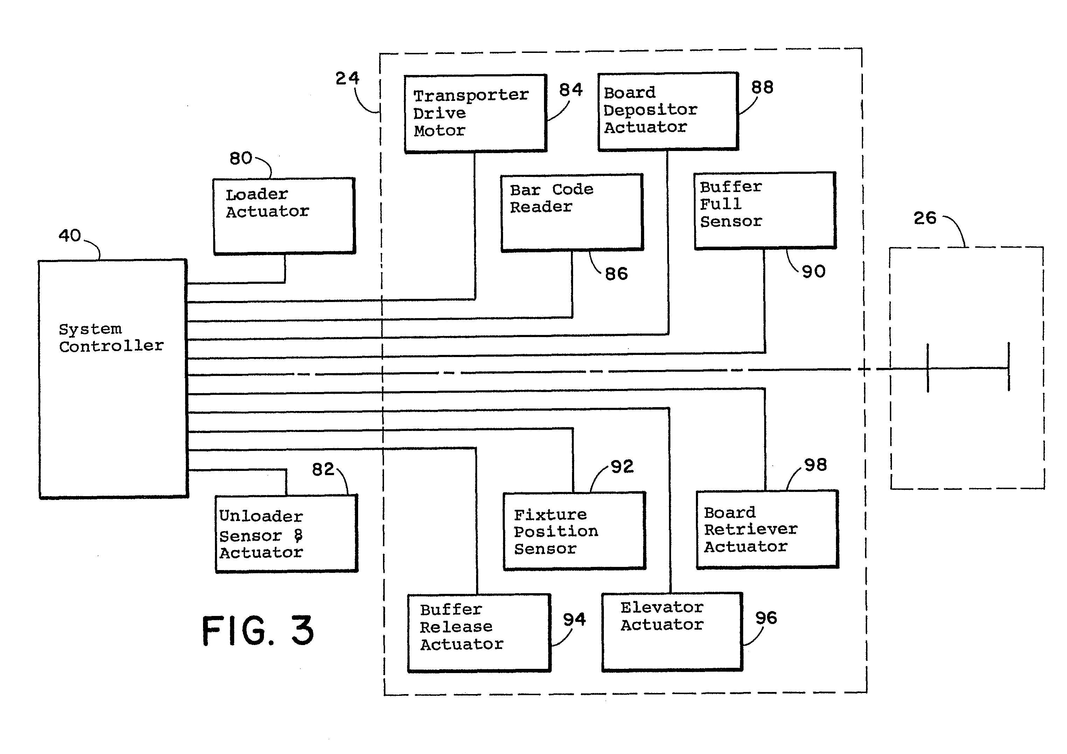

Turning now to Figure 3, the control system of the present invention is illustrated. The system controller 40, which is preferably a computer, is interconnected with a loader actuator 80, an unloader sensor and actuator 82, and all processing stations 24 and 26. The system controller controls the flow of printed circuit boards throughout the processing system 20. Acting on a predetermined schedule, the system controller directs the loader 30, through the loader actuator 80, to transfer printed circuit boards from the input carrousel 22 to the entrance region 34 of the transporter 36. Transporter 36, which consists of the conveyors 44 of the several processing stations, transports the printed circuit boards along the direction of travel 72 from the entrance region to each of the processing stations, then to the exit region 38. After the printed circuit boards have been processed by each of its scheduled processing stations, they are transported to the exit region. Whenever the unloader sensor and actuator 82 senses the presence of a printed circuit board at the exit region, it actuates the object unloader 42 to transfer the printed circuit board to the output carrousel 28.

The motion of the printed circuit boards is intermittent; the transporter periodically moves forward by a predetermined distance and then pauses. Loading, and unloading of printed circuit boards at the respective entrance and exit regions of the transporter, as well as off-loading and replacing of printed circuit boards at each processing station, are accomplished during the periods when the transporter is stopped. The system controller coordinates the motion of each conveyor 44 by controlling a transporter drive motor 84 within each processing station.

The system controller 40 determines the routing of each printed circuit board throughout the processing system 20.

Each individual printed circuit board may not require component insertion by each processing station. The system controller directs the off-loading operation of each station according to its predetermined processing schedule to ensure that each printed circuit board is processed by the proper sequence of insertion machines. To identify the printed circuit board 68 located beneath the board depositor handler 46, a bar code reader 86 is employed. Bar code reader 86 is positioned upstream of handler 46 and is operable for reading an encoded indetifying label affixed to each printed circuit board. If board 68 is scheduled for component insertion by insertion machine 52, the system controller directs the board depositer handler through a board depositer actuator 88 to off-load the board from the transporter.

The buffer storage unit 48 provides temporary storage of a stack 74 of printed circuit boards. If the insertion machine 52 should require maintenance or replenishment of components, the buffer storage unit may fill to its capacity. When this happens, a buffer full sensor 90 informs the system controller, which in turn adjusts the processing schedule and the flow of printed circuit boards through the processing system to compensate until that insertion machine is back on line.

The limiting factor in processing rate is the time required for component insertion. Whenever the insertion machine 52 is ready to begin inserting components into a printed circuit board, the fixture 50 is positioned under the buffer storage unit 48. A fixture position sensor 92 so informs the system controller 40, which in turn directs the buffer storage unit, through a buffer release actuator 94, to release the bottom-most printed circuit board of the stack 74. After receiving the printed circuit board, the fixture is repositioned by the insertion machine for component insertion. Upon completion of component insertion, the fixture moves to the fixture unload position 78. When
the fixture position sensor indicates that the fixture is
at the unload position, the system controller directs an
elevator actuator 96 to activate the elevator to transfer
the printed circuit board to the staging position 56. The
printed circuit board is replaced onto the transporter
during a period when the transporter is stopped and when no
printed circuit board is on the transporter below the board
retriever handler 58. At such time, the system controller
40 directs a board retriever actuator 98 to activate the
board retriever handler to transfer the board from the
staging position to the transporter.

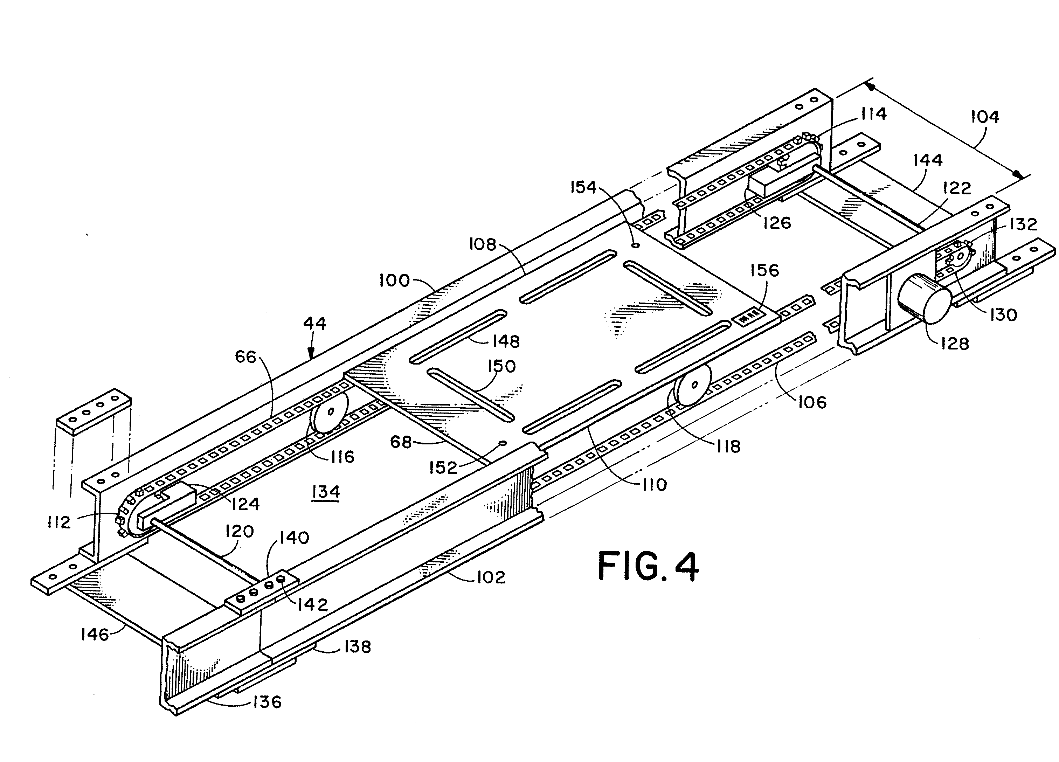

In reference now to Figure 4, the conveyor 44 of a processing station is illustrated. Two side rails 100 and 102
are parallel and horizontal and are spaced apart by a
distance 104 that is just slightly greater than the width
of printed circuit board 68. Two spaced apart belts 66 and
106 contact the printed circuit board beneath its two longitudinal edges 108 and 110 and provide the means for transporting the board. Each belt forms a continuous loop between two sprockets 112 and 114. Perforations in the belts
and cogs in the sprockets interlock so that no slipage can
occur therebetween. Idler rollers 116 and 118 are rotateably mounted to the side rails and act to support the belts
and printed circuit boards in the region between the
sprockets. The sprockets of the two belts are interconnected
at each end by two shafts 120 and 122 and rotate in unison.
Mounting blocks 124 and 126 provide means for rotateably
mounting sprockets 112 and 114 to the side rails. At one
end of the conveyor, a drive motor 128 provides drive means
through belt 130 and sprocket 132 for driving belts 68 and
106. Sprocket 132 is affixed to shaft 122, as is sprocket
114 for belt 66 and a sprocket (not shown) for belt 106.
When the drive motor 128 is on, it rotates sprocket 132
and shaft 122, which in turn drives both of the belts. In
the preferred embodiment, drive motor 128 is a stepper motor so as to provide distance sensing and control means for accurately advancing the belts by the predetermined distance during each transporter advance cycle.

Conveyor 44 advantageously has an open area 134 between the two belts 66 and 106. This open area provides clearance between the belts to allow the board depositor handler 46 to off-load printed circuit boards from the conveyor 44 to the buffer storage unit 48 directly below and to allow the board retriever handler 58 to transfer boards from the staging position to the conveyor. Such vertical movement of the printed circuit boards is advantageous in simplifying the handler mechanisms.

Adjacent conveyours are interconnected at the ends of their respective side rails 102 and 136. Plates 138 and 140 are fastened to two adjacent side rails and are secured by fasteners 142. Lateral plates 144 and 146 are fastened to the underside of the side rails and act to space the side rails apart by distance 104. The gap between the belts of an upstream conveyor and a downstream conveyor is small in comparison to the length of the printed circuit board, so that the boards are easily transferred from one conveyor to another.

All of the printed circuit boards have uniform outside dimensions to facilitate board handling. All of the circuitry and components of the finished printed circuit board are located within the area defined by slots 148. After component insertion and soldering has been completed, the tabs 150 between the slots 148 are trimmed away to yield the finished printed circuit board. This permits flexibility in final board size, while providing a standard board size during processing. Although a single finished printed circuit board is illustrated within board 68 in Figure 4, several finished boards of various shapes could be accomodated. Included in the area between the slots and the edges of the printed circuit board are alignment holes 152 and 154 for alignment of the board on the fixture 50 and a bar code label 156 for board identification.

The two board handlers, board depositor handler 46 and board retriever handler 58, are identical in design and construction. One embodiment of the board handlers is illustrated in Figure 5. The board handler generally includes a support plate 158, upper and lower moveable plates 160 and 162, two object grasping mechanisms 164 and 166 and a first pneumatic cylinder 168.

Support plate 158 is a generally rectangular shaped plate that provides support means for supporting the board handler above the conveyor. Two support posts 170 and 172 support one end of the support plate above side rail 100, and two additional support posts 174 and 176 support the other end of the support plate above side rail 102. The four support posts retain the support plate in a fixed horizontal orientation above the conveyor. Support plate 158 has several areas 178 removed to reduce weight. The first pneumatic cylinder 168 is disposed vertically with the rod end of the cylinder fastened to the center of support plate 158 and with the cylinder protruding upward and the rod protruding downward.

The upper and lower moveable plates 160 and 162 provide moveable plate means for vertical travel to raise and lower a printed circuit board. Moveable plates 160 and 162 are generally rectangular in shape and have areas 180 and 182 removed to reduce weight. Two vertical guide shafts 184 and 186 are fastened at 188 and 190 to upper plate 160 and to lower plate 162 to join the two plates together. Guide shafts 184 and 186 are slideably coupled to the support plate 158 with two bushings 192 and 194, and act to guide the vertical movement of moveable plates 160 and 162. Guidance is also provided by the first pneumatic cylinder 168. Three guide wheels 196 and 198 are disposed on the upper plate 160 and rotate about horizontal axes defined by axles 200 and 202 attached to the upper plate. The guide wheels contact the outer surface of cylinder 168 to guide the upper plate as it moves up and down. The rod of the first pneumatic cylinder provides a first actuator rod 204 that extends downwardly from the cylinder and is attached to the lower plate 162. When the first actuator rod is retracted, the moveable plates are raised to their upper position, as illustrated in Figure 5. When the first actuator rod is extended, the moveable plates are lowered to their lower position. During movement between the upper and lower positions, guide shafts 184 and 186, bushings 192 and 194, cylinder 168, and guide wheels 196 and 198 act to keep the upper and lower moveable plates in a spaced apart and horizontal orientation.

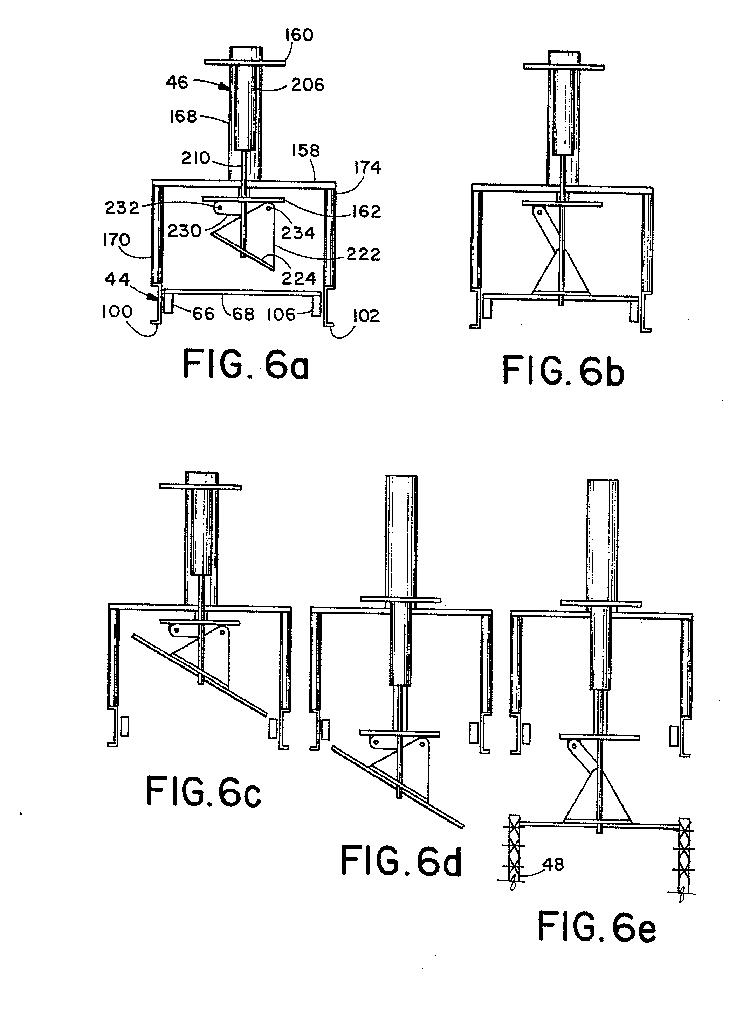

The two object grasping mechanisms 164 and 166 provide means for grasping, tilting, and releasing a printed circuit board. The motive force for the object grasping mechanisms are provided by second and third pneumatic cylinders 206 and 208. Cylinders 206 and 208 are oriented vertically and are fastened at one end to the underside of the upper plate 160. Second and third actuator rods 210 and 212 of cylinders 206 and 208, respectively, protrude vertically downward and pass through bushings 214 and 216 in the lower plate 162. The lower ends of actuator rods 210 and 212 have lift pins 218 and 220 affixed thereto. Lift pins 218 and 220 are short and cylindrical in shape and are oriented horizontally. A clamping bracket 222 is positioned proximate actuator rod 210 between lower plate 162 and lift pin 218. Clamping bracket 222 has a flange 224 with a slot 226 therein, and is positioned such that actuator rod 10 passes through the slot. A Compression spring 228 is disposed on actuator rod 210 between lower plate 162 and flange 224. A pivot lever 230 joins the upper end of the clamping bracket to the lower plate. Pivot lever 230 is coupled to the underside of the lower plate at pivot 232 (see Figure 6a) and to the upper end of the clamping bracket at pivot 234. A similar clamping bracket, spring, and pivot lever are provided at actuator rod 212.

The second and third pneumatic cylinders 206 and 208 are operable for rotating, as well as extending and retracing, the second and third actuator rods 210 and 212. Actuator rods 210 and 212 rotate between two positions: a release position as one shown in Figure 5 wherein the two lift pins 218 and 220 are parallel and point transversely to the direction of travel 72, and a grasping position where the two lift pins point toward each other and are parallel to the direction of travel. The distance between the second and third actuator rods 210 and 212 is just slightly greater than the length of the printed circuit board. When the lift pins are in the release position, actuator rods 210 and 212 can be extended and retracted without contacting the printed circuit board. When the lift pins are in the grasping position, the lift pins are spaced apart by a distance that is less than the lenght of the printed circuit board, and, accordingly, contact the printed circuit board.

The operation of the board depositer handler 46 is illustrated in Figures 6a-6e. In Figure 6a, all three actuator rods 204, 210 and 212 are retracted to raise the handler above the conveyor 44 to provide clearance for the passage of printed circuit board 68. Lift pins 218 and 220 are in the release position, pointing transversely to the direction of tranvel. When the second and third actuator rods 210 and 212 are retracted, lift pins 218 and 220 lift the flange 224 of clamping bracket 222. Since the upper end of clamping bracket 222 is pivotably attached to pivot lever 230, lifting the clamping bracket causes it to tilt to the position shown. The board depositor handler remains in this position until directed by the board depositor actuator 88 to off-load a printed circuit board positioned directly below.

In Figure 6b, the board depositor handler 46 has begun to off-load a printed circuit board 68. With the lift pins 218 and 220 in the release position, the second and third actuator rods 210 and 212 are extended. Springs 228 lower the clamping brackets as actuator rods 210 and 212 extend. The underside of clamping brackets 222 contact the top of the printed circuit board along its two lateral sides. The lift pins and the lower portions of actuator rods 210 and 212 extend into the open area between belts 66 and 106 and below the printed circuit board. Next, the lift pins are rotated to face each other in the grasping position, and actuator rods 210 and 212 are raised. The lift pins contact the underside of the printed circuit board and lock it against the flanges 224 of the clamping brackets 222. As the lift pins raise the printed circuit board and clamping brackets, to pivot levers cause the clamping brackets and board to tilt to the position shown in Figure 6c.

To lower the printed circuit board to the buffer storage unit 48 below, the first pneumatic cylinder 168 extends the first actuator rod 204. This action lowers the moveable plates 160 and 162, as well as the grasping mechanisms 164 and 166 and the printed circuit board 68. Since the printed circuit board is tilted, there is adequate clearance between the belts 66 and 106 of the conveyor to permit the board to pass. When the first actuator rod is fully extended, the handler is in the position illustrated in Figure 6d. Then, the second and third actuator rods 210 and 212 are extended to level the printed circuit board and place it upon the uppermost roller assembly of the buffer storage unit, as illustrated in Figure 6e.

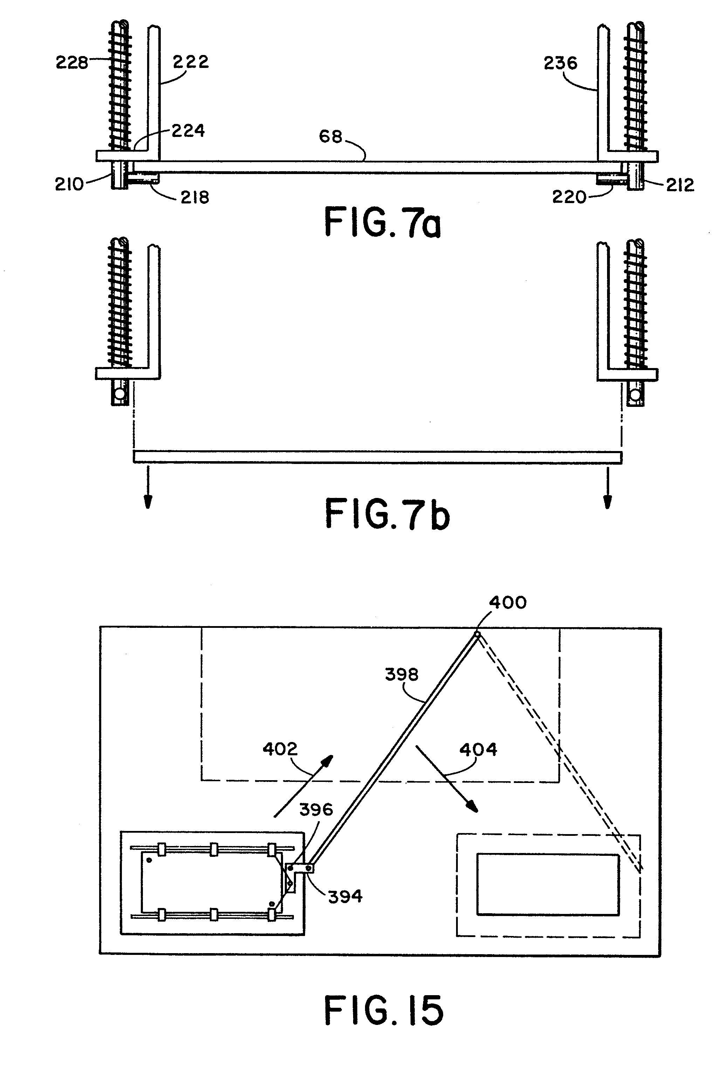

After the printed circuit board has been lowered to the buffer storage unit, the board depositor handler releases the board. As shown in Figure 7a, the printed circuit board 68 is grasped between the lift pins 218 and 220 and the clamping brackets 222 and 236 when the lift pins are at the grasping position. To release the printed circuit board, the second and third actuator rods 210 and 212 are rotated to move the lift pins to the release position shown in Figure 7b. This permits the printed circuit board to descent to the top of the stack of boards in the buffer storage unit 48. After releasing the printed circuit board, the handler retracts the three actuator rods 204, 210, and 212 to return to the position shown in Figure 6a.

The board retriever handler 58 operates in a similar fashion, but in a reverse sequence of steps. To transfer a printed circuit board to the conveyor 44 from the staging position 56, the board retriever handler first extends its three actuator rods, with its lift pins in the release position. The actuator rods are extended until the clamping brackets contact the printed circuit board and the lift pins are below the board. Then the second and third actuator rods are rotated to bring the lift pins to the grasping position. Next, the second and third actuator rods are retracted to tilt the printed circuit board to the position shown in Figure 6d. The first actuator rod is then retracted to lift the printed circuit board through the open area between the belts of the conveyor. Once above the belts, the second and third actuator rods extend to level and place the printed circuit board onto the belts. The second and third actuator rods are then rotated to bring the lift pins to the release position, releasing their grasp of the printed circuit board. Finally, the second and third actuator rods are retracted to lift the clamping brackets and lift pins above the conveyor.

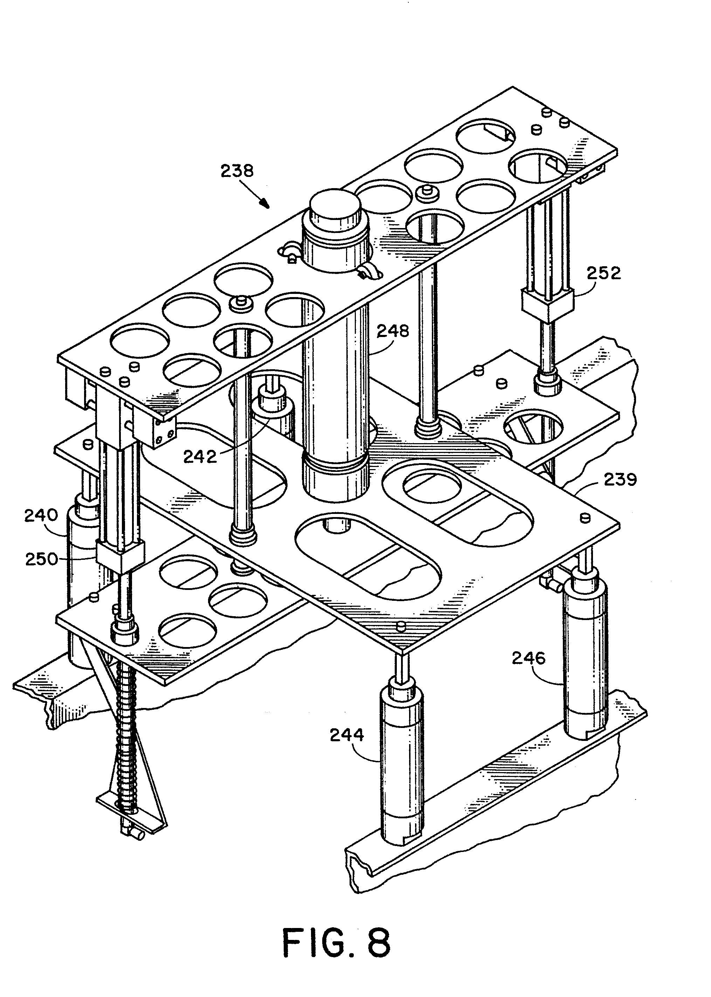

An alternative board handler 238 is illustrated in Figure 8. Board handler 238 differs from the above described board handler in its support structure and method of lifting the printed circuit board from the conveyor. Instead of fixedly mounting the support plate 239 to support posts 170, 172, 174, and 176, board handler 238 has the support plate mounted to four pneumatic cylinders 240, 242, 244 and 246. These cylinders are operable for raising and lowering the support plate of board handler 238, while keeping the support plate horizontal. Board handler 238 also has first, second and third pneumatic cylinders 248, 250, and 252 that operate in a fashion similar to cylinders 168, 206, and 208.

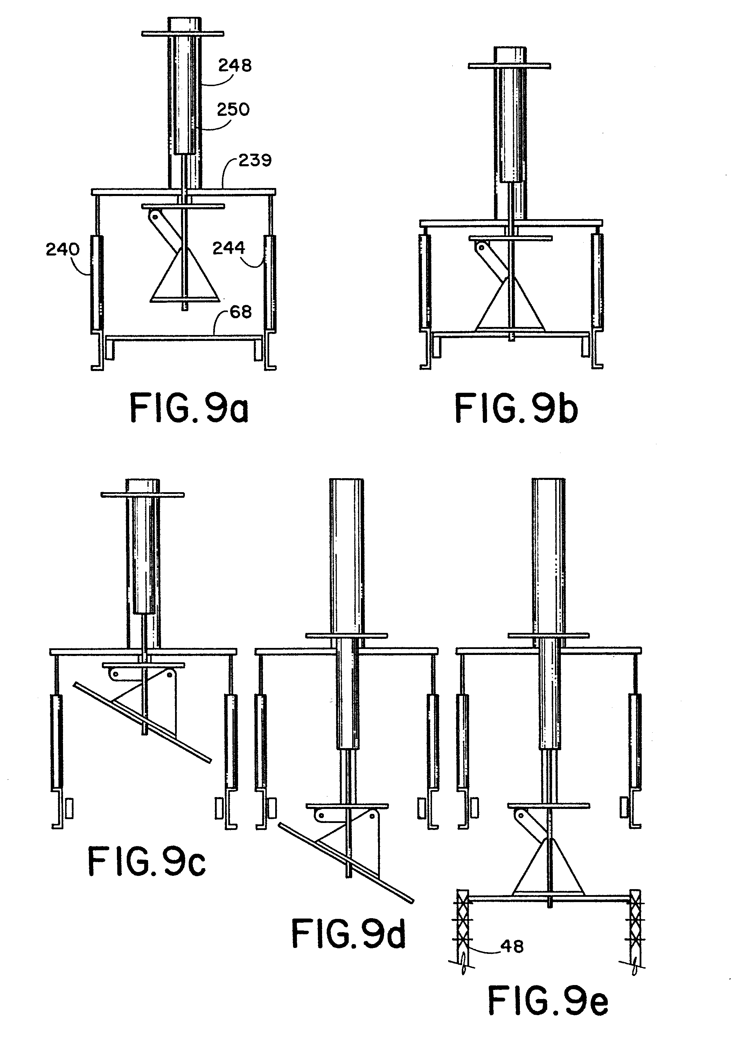

Figures 9a-9e illustrate the operation of board handler 238. When the conveyor belts are moving, cylinder 248 is retracted and cylinders 240, 242, 246, 250, and 252 are extended. This keeps the flange of the clamping bracket at a horizontal orientation, as shown in Figure 9a. When a printed circuit board is to be off-load, cylinders 240, 242, 244 and 246 retract to bring the clamping brackets into contact with the board. The lift pins are then moved to their clamping position under the printed circuit board, and cylinders 250 and 252 retract to tilt the board and cylinders 240, 242, 244 and 246 extend to lift the board from the conveyor.

From this point on, the operation of board handler 238 is the same as that of board handler 46. Cylinder 248 extends to lower the printed circuit board through the open area between the belts of the conveyor. Then cylinders 250 and 252 extend to level the printed circuit board and to place it on the uppermost roller assembly of the buffer storage unit 48. Then the lift pins are moved to the release position to release the printed circuit board. To return board handler 238 to its starting position, cylinder 248 retracts to lift the moveable plates and grasping mechanisms above the conveyor. One adavantage to board handler 238 is that cylinder 250 and 252 need by cycled only once during each off-load sequence, instead of twice as with board handler 46.

The buffer storage unit 48 illustrated in Figure 10 is positioned directly below the board depositer handler 46 and provides temporary storage of a stack 74 of printed circuit boards. It is composed of a frame 254, several roller assemblies 76, and a release mechanism 256. Frame 254 is a rectangular prism in shape and has a top frame 258 and a bottom frame 260 joined by four upright members 262, 264, 266, and 268. The frame is preferably composed of steel bars that are welded or otherwise fastened to form a rigid structure. Frame 254 is attached to the side rails 100 and 102 of the conveyor 44.

Each of the roller assemblies includes two axles 270 and 272, four star wheels 274, 276, 278, and 280 attached to the ends of the two axles, and a belt mechanism 282 to couple the rotation of the two axles. The two axles are hexagonal in cross-section and have rounded ends that rotate in corresponding mounting holes 284 in the upright members 262, 264, 266, and 268. Axles 270 and 272 are parallel and horizontal and are spaced apart by a distance slightly greater than the width of the printed circuit boards. Two star wheels are attached to each axle just inside the upright members of the frame. Each star wheel has six equally spaced spokes radiating outwardly from the axle. The spokes are utilized to support the printed circuit boards of the stack as will be described below. The axles protrude past the upright member and have sprockets 286 and 288 affixed thereto. Between and in engagement with the sprockets is disposed a toothed belt 290. Belt 290 forms a figure eight which interconnects the rotations of the two axles so that the axles always counterrotate by an equal amount.

Several roller assemblies are mounted on the frame to provide means for guiding the descent of printed circuit boards and for spacing apart the boards in the stack 74. The two axles of each roller assembly are mounted between upright members 264 and 268 and between members 262 and 266. All axles are oriented horizontally and are uniformly spaced apart.

The axles 292 and 294 of the bottom-most roller assembly are connected to the release mechanism 256. Release mechanism 256 has two release cam mechanisms 296 and 298, each coupled to axles 292 and 204. Pneumatic cylinders 300 and 302 provide release actuator means to operate the release mechanism 256. The purpose of the release mechanism is to rotate axles 202 and 204 by one-sixth of a revolution upon the receipt of a release command from the control system 40.

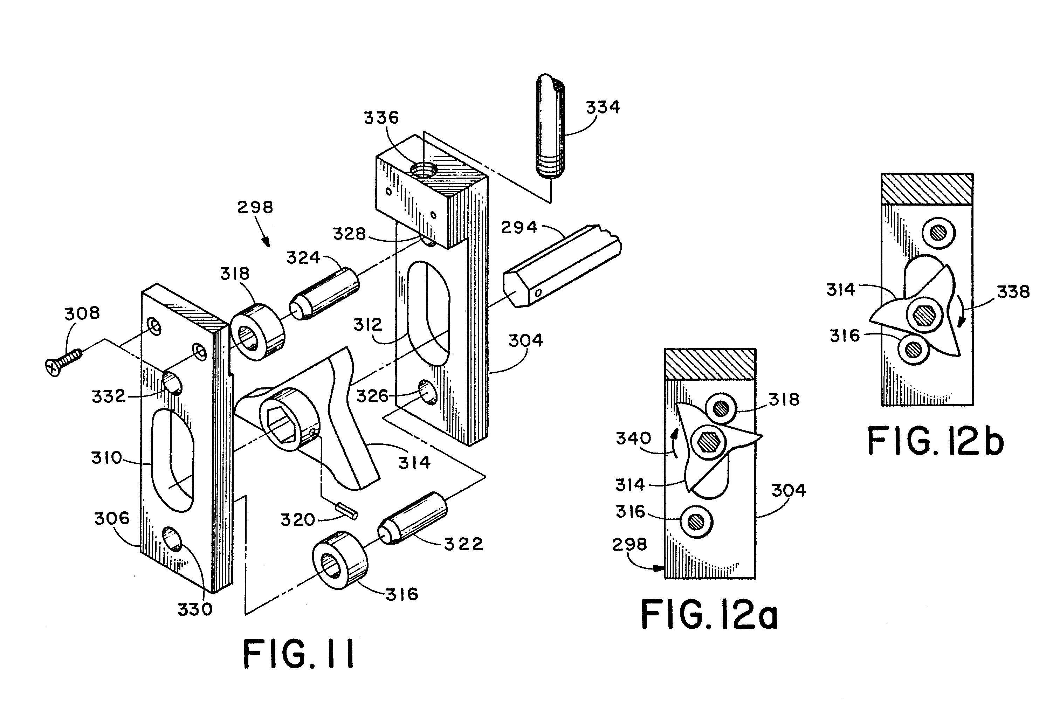

Figure 11 illustrates the components within the release cam mechanism 298. Inner and outer plates 304 and 306 are joined together with screw fasteners 308 to form a release frame. Two slots 310 and 312 provide clearance between plates 304 and 306 and axle 294. Between the plates are mounted a three sided cam 314 and two cam rollers 316 and 318. The three sided cam 314 is mounted on the end of axle 294 and is locked in place with pin 320. Cam rollers 316 and 318 mount on and are rotatable about axles 322 and 324. Axles 322 and 324 are mounted at each end thereof into holes 326, 328, 330 and 332 in the inner and outer plates. An actuator rod 334 of cylinder 300 has a threaded lower end which is screwed into a corresponding threaded hole 336 in the top of the inner plate 304.

Figures 12a and 12b illustrate the operation of the release mechanism. To actuate the release mechanism when it is in the position shown in Figure 12a, the actuator rod 334 is raised by cylinder 302. When the actuator rod raises, the cam release mechanism 298 also raises. Cam roller 316 then contacts a surface of cam 314 and rotates it in direction 338 to the position shown in Figure 12b. This rotates the attached axle 294 clockwise by one-sixth of a revolution. For the next actuation, cylinder 300 lowers rod 334 and mechanism 298 to bring cam roller 318 into contact with cam 314, causing another clockwise rotation 340 of one-sixth of a revolution.

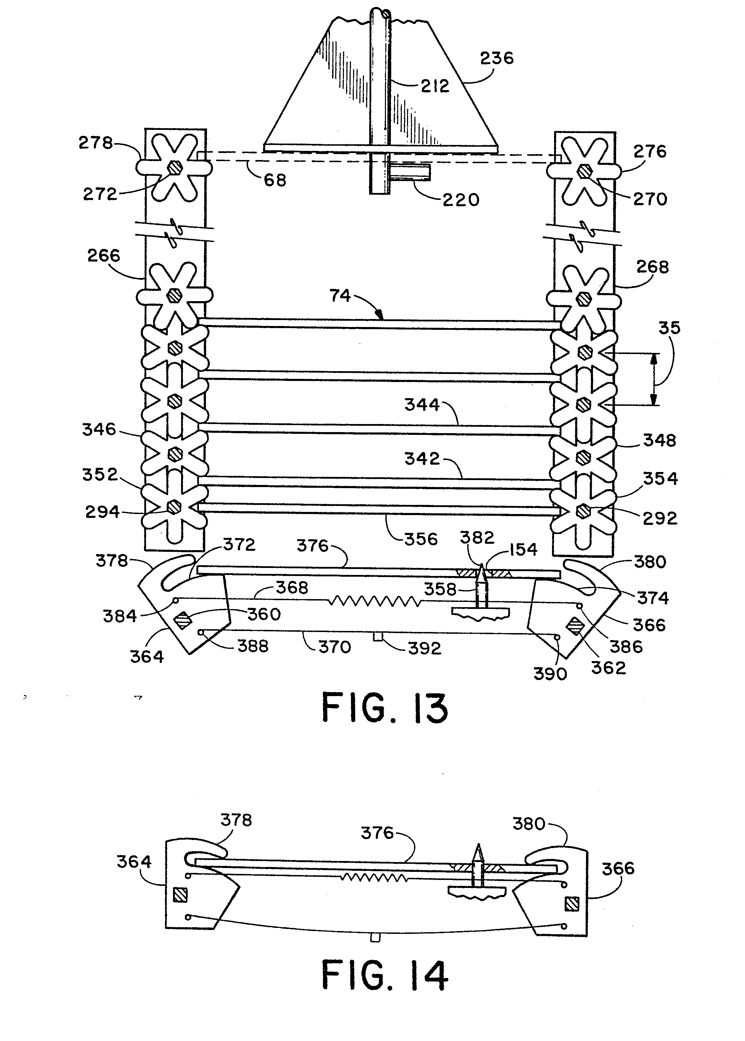

In Figures 13 and 14, the operation of the buffer storage unit 48 and the fixture 50 are illustrated. As described above, the board depositor handler 46 places a printed circuit board 68 onto the star wheels 276 and 278 of the upper-most roller assembly. Due to the weight of board 68, star wheel 278 and axle 272 will rotate clockwise and star wheel 276 and axle 270 will rotate counterclockwise, allowing the board to descend. Assuming that the buffer storage unit is initally empty, board 68 will descend until it reaches the bottom-most roller assembly at 342. Since the release mechanism 256 prevents the bottom-most roller assembly from rotating, the board stays at position 342. The next printed circuit board to be off-loaded from the conveyor and placed in the top of the buffer storage unit will descend to position 344. Star wheels 346 and 348 are prevented from turning due to the presence of a printed circuit board at 342, and thus support the board at position 344. In this fashion, the star wheels of the buffer storage unit act to space apart the printed circuit boards of the stack. Spaces between the printed circuit boards are required to provide clearance for components that are inserted into the boards. The roller assemblies are spaced apart vertically by distance 350 as determined by the dimensions of the star wheels and the thickness of the printed circuit boards.

Each time that the release mechanism 256 is actuated, star wheel 352 and axle 294 rotate clockwise by one-sixth of a revolution and star wheel 354 and axle 292 rotate counterclockwise by one-sixth of a revolution. The first actuation of the release mechanism moves the first loaded printed circuit board to position 356. All sucessive actuations of the release mechanism drops the bottom-most printed circuit board to the fixture below and moves the next higher board from position 342 to position 356. During each actuation, as the bottom-most printed circuit board is released, all boards positioned above move down by one position. The buffer storage unit 48 thus serves as a first-in-first-out buffer.

Fixture 50 is positioned below the buffer storage unit 48 when a printed circuit board is released. The fixture serves to receive the board from the buffer storage unit, to align the board with respect to alignment pins 358 on the fixture, to position the board under the direction of the insertion machine 52 during component insertion, and to move the board to the fixture unload position 78 when component insertion is finished. To receive and align the printed circuit board, the fixture includes two clamping shafts 360 and 362, that are pivotably mounted, several clamping cams 364 and 366 fixedly mounted to each clamping shaft, a spring 368 to bias the clamping cams toward a clamped position, and a wire 370 to open the clamping cams to a released position when the fixture is either under the buffer storage unit or at the fixture unload position.

The clamping cams have support surfaces 372 and 374 for supporting a printed circuit board 376 in the fixture. When the clamping cams are at the clamped position, as shown in Figure 14, fingers 378 and 380 act to hold board 376 against the support surfaces of the clamping cams. When the clamping cams are at the released position, as shown in Figure 13, the fingers are pivoted back out of the way and do not contact the board. Support surfaces 372 and 374 are shaped such that board 376 is at a more elevated position when the clamping cams are at the released position than at the clamped position.

The fixture 50 aligns the printed circuit board 376 with respect to the fixture when the clamping cams move from the released position to the clamped position. Alignment pin 358 has a conical portion 382 that enters alignment hole 154 in the board when the board is released by the buffer storage unit. The conical shape of the top of alignment pin 358 compenstates for misalignment between the buffer storage unit and the fixture. When the clamping cams move to the clamped position, the board is lowered onto the cylindrical portion of the alignment pin to provide precise alignment.

Spring 368 and wire 370 move the clamping cams 364 and 366 between the released and clamping positions. Spring 368 is disposed in tension between pin 384 on clamping cam 364 and pin 386 on clamping cam 366. Since pins 384 are positioned above the clamping shafts 360 and 362, the spring tends to move the clamping cams toward the clamped position. Wire 370 is disposed between pin 388 on clamping cam 364 and pin 390 on clamping cam 366. Since pins 388 and 390 are positioned below the clamping shafts, tension on the wire tends to counteract the tension in the spring and move the clamping cams toward the released position. A fitting 392 attaches the center of wire 370 to one end of a lever 394, as shown in Figure 15. The center 396 of lever 394 is pivotably attached to the fixture, and the other end of the lever is attached to one end of a tether 398. The other end of tether 398 is fixedly attached at 400 to the insertion machine 52. The length of tether 398 and its attachment point are selected so as to provide sufficient tension in wire 370 to move the clamping cams to the released position when the fixture is under the buffer storage unit or at the fixture unload position. When the fixture moves from under the buffer storage unit along arrow 402, the tether loosens to allow spring 368 to move the clamping cams to the clamped position to align and clamp the printed circuit board. When component insertion is completed and the fixture moves along arrow 404 to the fixture unload position, tension in the tether causes the clamping cams to pivot to the released position to release the printed circuit board.

From the above description, it will be apparent that the invention disclosed herein provides a novel and advantageous automatic object transporter apparatus. As will be understood by those familiar with the art, the invention may be embodied in other specific forms without departing from the spirit or essential characteristics thereof. Accordingly, the disclosure of the present invention is intended to be illustrative, but not limiting, of the scope of the invention, which is set forth in the following claims.

27          0135117

What is claimed is:

1.  An object transporter apparatus for automatically
    transporting objects to and from processing means,
    where said processing means performs processing
    operations upon said objects, said apparatus
    comprising:
    transporter means for unidirectionally conveying said
    objects along a direction of travel from an entrance
    region thereof to an exit region thereof, said
    transporter means comprising two spaced apart belts
    forming an open area therebetween and extending from
    said entrance region to said exit region;
    first handler means disposed adjacent to said transporter means and between said entrance and exit regions
    for off-loading said objects from said transporter
    means;
    buffer storage means disposed below said first handler
    means for temporary storage of a stack of one or more
    of said objects, said buffer storage means is operable
    for receiving objects from said first handler means
    and placing said objects onto the top of said stack,
    and for selectively releasing a said objects from the
    bottom of said stack;
    fixture means disposed below said buffer storage means
    for receiving objects released from the bottom of said
    stack, for positioning said objects within said processing means to permit said processing means to perform said processing operations upon said objects, and
    for positioning said objects at a fixture unload
    position away from said buffer storage means and said
    processing means after said processing operations have
    been completed;
    elevator means for transferring objects from said
    fixture unload position to a staging position adjacent
    to said transporter means;
    second handler means disposed adjacent to said staging
    position for transferring said objects from said staging position to said transporter means; and control means coupled to said first handler means, said buffer storage means, said fixture means, said elevator means, and said second handler means for controlling the flow of objects through said apparatus by directing said first handler means to off-load objects from said transporter means to said buffer storage means, by directing said buffer storage means to selectively release said objects onto said fixture means, and by directing said elevator means and said second handler means to replace said objects onto said transporter means.

2. An apparatus as in claim 1 wherein: each of the objects is planar and unifomr in size and has two longitudinal edges; and
the spaced apart belts of the transporter means are disposed substantially parallel to each other and are operable for contacting said objects adjacent to said longitudinal edges.

3. An apparatus as in claim 2 wherein said transporter means additionally comprises:
two substantially parallel side rails defining lateral boundaries of a path from the entrance region to the exit region of said transporter means, said side rails are operable for laterally constraining said objects being transported by said transporter means; and
drive means coupled to the two belts for simultaneously driving said belts in a recirculating fashion.

4. An appartus as in claim 3 wherein:
the drive means comprises sprockets and motor means, said sprockets are rotatably mounted to the side rails and are operable for rotation about axes that are horizontal and perpendicular to the path, said motor means are operable for driving said sprockets in rotation;

the two spaced apart belts are perforated and are disposed in engagement with the teeth of said sprockets, said belts are operable for recirculation such that the upper surfaces thereof travel in a direction toward the exit region; and

the objects are transported along said path from said entrance region toward said exit region through contact with said upper surfaces of said belts.

5. An apparatus as in claims 4 wherein:
the drive means further comprises distance sensing means for measuring belt travel distance;
and wherein said drive means intermittently advances said belts by a predetermined distance.

6. An apparatus as in claim 5 wherein the motor means and the distance sensing means are a stepper motor.

7. An apparatus as in claim 1 wherein:
each of the objects is planar and uniform in size and has two longitudinal edges parallel to the direction of travel of the transporter means and two transverse edges substantially perpendicular to the direction of travel of said transporter means; and said first handler means is operable for off-loading an object from the transporter means by grasping said two transverse edges of said object and lifting said object from the belts, then tilting said object and lowering it through the open area between said belts, then releasing said object at a point below said transporter means.

8. An apparatus as in claim 7 wherein the first handler means comprises:
support means coupled to the transporter means for supporting said first handler means above said transporter means;

moveable plate means slideably coupled to said support means for vertical travel between an upper position and a lower position;

object grasping means coupled to said moveable plate means for grasping and tilting an object when said moveable plate means is at said upper position and for releasing said object when said moveable plate means is at said lower position; and

first actuator means affixed to said support means and coupled to said moveable plate means for moving said moveable plate means between said upper and lower positions.

9. An apparatus as in claim 8 wherein said moveable plate means comprises:

an upper plate disposed above said support means;

a lower plate disposed below said support means and fixedly coupled to said upper plate; and

guide means affixed to said upper and lower plates and slideably coupled to said support means for guiding said upper and lower plates between the upper position and the lower position;

and wherein the first actuator means includes a first actuator rod that extends downwardly from said first actuator means and is coupled at the lower end thereof to said lower plate, said first actuator means is operable for moving said first actuator rod between a retracted position where said moveable plate means is at said upper position and an extended position where said moveable plate means is at said lower position.

10. An apparatus as in claim 9 wherein said guide means comprises two vertical guide shafts disposed between and affixed to the upper and lower plates and two corresponding bushings affixed to the support means and slideably coupled to said guide shafts, said bushings are operable for guiding said guide shafts as said moveable plate means moves between the upper and lower positions, said guide means also comprises a plurality of rollers rotatably coupled to said upper plate and disposed in rolling contact with said first actuator means, said rollers are operable for guiding said upper plate as said moveable plate means moves between said upper and lower positions.

11. An apparatus as in claim 9 wherein said object grasping means comprises:

second and third actuator rods disposed vertically and slideably coupled to the moveable plate means, said second and third actuator rods are spaced apart by a distance greater than the longitudinal length of the object;

second and third actuator means affixed to the upper plate for extending, rotating, and retracting said second and third actuator rods, respectively, said second and thrid actuator means are operable for extending said second and third actuator rods into the space between the spaced apart belts of the transporter means when said moveable plate means is at the upper position;

two lift pins, each affixed to the lower end of one of said second and third actuator rods and oriented at substantially right angles to the axes thereof;

two pivot levers, each disposed proximate one of said second and third actuator rods and pivotably coupled at one end thereof to said lower plate;

two clamping brackets, each pivotably coupled to the other end of said pivot levers and slideably coupled to one of said second and third actuator rods at a position above said lift pins; and

biasing means for biasing said clamping brackets toward said lift pins;

and wherein said object grasping means is operable for grasping an object by extending said second and third actuator rods, with said lift pins pointing transversely, until said clamping brackets are resting upon the upper surface of said object proximate the transverse edges thereof and said lift pins are below said object, then rotating said second and third actuator rods until said lift pins point toward each other, then retracting said second and third actuator rods to lift said lift pins against said object;

and wherein said object grasping means is operable for tilting said object by continuing to retract said second and third actuator rods, thereby causing said pivot levers to pivot about their respective pivotable couplings and causing said clamping brackets and said object to tilt;

and wherein said object grasping means is operable for releasing said object by rotating said second and third actuator rods until said lift pins are no longer below said object.

12. An apparatus as in claim 11 wherein said object grasping means is oberable for lifting the object from the transporter means by retracting the second and third actuator rods.

13. An apparatus as in claim 11 wherein said first handler means further comprises support lifting means disposed between the support means and the transporter means for lifting the object from said transporter means by lifting said support means.

14. An apparatus as in claim 1 wherein each of the objects is planar and uniform in size and has two longitudinal edges; and

said buffer storage means comprises:

a frame;

a plurality of roller means, pivotably coupled to said frame, for uniformly spacing apart said objects in the stack, said roller means are operable for receiving an object from the first handler means and for placing said object upon the top of said stack; and

release means for releasing the bottom-most object of said stack upon command from the control means.

15. An apparatus as in claim 14 wherein each of said plurality of roller means comprises:

two axles rotatably coupled to said frame, said two axles are parallel and lie in a horizontal plane and are spaced apart by a distance greater than the distance between the two longitudinal edges of the objects;

star wheels affixed to and rotatable with said axles, one of said axles having at least two star wheels affixed thereto and the other of said exles having at least one star wheel affixed thereto, each of said star wheels having a plurality of uniformly spaced apart spokes protruding radially therefrom, said spokes are operable for contacting said longitudinal edges of said objects; and

interconnection means for coupling the rotations of said two axles such that said two axles counter-rotate by an equal amount;

and wherein said plurality of roller means are positioned such that said axles of said plurality of roller means lie in two vertical and parallel planes, said axles are vertically spaced apart such that said star wheels of an upper one of said roller means are prevented from rotating by the presence of one of said objects supported by a lower one of said roller means.

16. An apparatus as in claim 15 wherein said interconnection means for each roller means comprises two pulleys, each affixed to and rotatable with one of the axles, and a belt coupled to said pulley and disposed in a figure eight pattern therebetween.

17. An apparatus as in claim 15 wherein said buffer storage means is operable for forming the stack of objects by preventing the axles of the bottom-most roller means from rotating, thereby supporting a bottom-most object with the star wheels of said bottom-most roller means, and wherein said buffer storage means is operable for releasing said bottom-most object by allowing said axles of said bottom-most roller means to rotate by an amount sufficient to permit said bottom-most object to drop.

18. An apparatus as in claim 17 wherein said star wheels have six uniformly spaced apart spokes protruding radially therefrom, and wherein said release means is operable for allowing the two axles of the bottom-most roller means to rotate by one-sixth of a revolution.

19. An apparatus as in claim 18 wherein said release means comprises:
a three sided cam affixed to and rotatable with one of the axles of the bottom-most roller means;
a release frame disposed proximate said cam;
two cam rollers coupled to said frame, one of said cam rollers is disposed above said cam and the other one of said came rollers is disposed below said cam; and
release actuator means coupled to said frame and operable for reciprocally moving said release frame to alternately bring each of said cam rollers into contact with said cam, wherein said cam rotates by one-sixth of a revolution upon each such contact.

20. An apparatus as in claim 1 wherein the processing means includes fixture displacement means for sequentially positioning the fixture means under the buffer storage unit, within said processing means, and at the fixture unload position, and wherein said fixture means comprises:

object alignment means for aligning one of said objects with respect to said fixture means;

object clamping means for clamping said one of said obejcts against said alignment means during the processing operations, and for releasing said one of said objects after said processing operations have been performed; and

clamping actuator means coupled to said processing means and to said object clamping means for actuating said object clamping means during said processing operations, and for releasing said object clamping means when said fixture means is under said buffer storage unit or at said fixture unload position.

21. An apparatus as in claim 20 wherein each of the objects are planar and uniform in size and have two alignment holes therethrough, and wherein said object alignment means comprises two alignment pins, said alignment pins are disposed vertically upward on said fixture means and are spaced apart by a distance equal to the distance between said alignment holes of said objects.

22. An apparatus as in claim 21 wherein each of the alignment pins is tapered and includes an upper conical portion and a lower cylindrical portion, said upper conical portion and said lower cylindrical portion are disposed about the same vertical axis and form a smooth transition therebetween, said lower cylindrical portion having a diameter substantially equal to the diameter of said alignment holes.

23. An apparatus as in claim 20 wherein each of the objects are planar and uniform in size and have two longitudinal edges, and wherein said object clamping means comprises:
two clamping shafts rotatably coupled to the fixture means, said clamping shafts are disposed parallel and lie in a horizontal plane and are spaced apart by a distance greater than the distance between said longitudinal edges of said objects; and
one or more clamping cams affixed to and rotatable with each of said two clamping shafts, said clamping cams and said clamping shafts are moveable by said clamping actuator means between a released position and a clamped position, each of said clamping cams has a support surface and a finger positioned above said support surface, said clamping means is operable for supporting one of said objects upon said support surfaces when said clamping cams are at said released position, said clamping means is also operable for lowering said one of said objects onto the object alignment means and for grasping said longitudinal edges of said one of said objects between said support surfaces and said fingers as said clamping cams and shafts rotate from said released position to said clamped position.

24. An apparatus as in claim 23 wherein the clamping actuator means comprises:
biasing means coupled to the clamping shafts for biasing said clamping shafts toward the clamped position;
and
a tether affixed at one end thereof to the processing means and coupled at the other end thereof to said clamping shafts, said tether is operable for counteracting said biasing means and moving said clamping shafts and cams to the released position whenever the fixture means is under the buffer storage unit or is at the fixture unload position.

25. An apparatus as in claim 7 wherein said second handler means is operable for transferring an object from the staging position to the transporter means by grasping and tilting said object, then lifting said object through the open area between the belts of said transporter means, then leveling said object and placing it upon said belts, then releasing said object.

26. An apparatus as in claim 25 wherein the second handler means comprises:
support means coupled to the transporter means for supporting said second handler means above said transporter means;
moveable plate means slideably coupled to said support means vertical travel between an upper position and a lower position;
object grasping means coupled to said moveable plate means for grasping and tilting an object when said moveable plate means is at said lower position and for releasing said object when said moveable plate means is at said upper position; and
first actuator means affixed to said support means and coupled to said moveable plate means for moving said moveable plate means between said upper and lower positions.

27. A processing system for automatically performing processing operations upon objects, each of said processing operations being performed on each of said objects by one or more of a plurality of processing means, said system comprising:
transporter means for unidirectionally conveying said objects along a direction of travel, said transporter means comprising two spaced apart belt means forming an opean area therebetween, said belt means are operable for transporting said objects from an entrance region to an exit region thereof;

object loading means for loading said objects onto said entrance region of said transporter means;

a plurality of processing stations disposed along the length of said transporter means, each of said processing stations is operable for selevtively transporting said objects to and from one of said processing means, each of said processing stations comprising:

first handler means disposed adjacent to said transporter means for off-loading, from said transporter means, objects to be processed by the processing means associated with said processing station;

buffer storage means disposed below said first handler means for temporary storage of a stack of one or more of said objects, said buffer storage means is operable for receiving objects from said first handler means and placing said objects onto the top of said stack, and for selectively releasing objects from the bottom of said stack;

fixture means disposed below said buffer storage means for receiving objects released from the bottom of said stack, for positioning said objects within said processing means to permit said processing means to perform said processing operations upon said objects, and for positioning said objects at a fixture unload position away from said buffer storage means and said processing means after said processing operations have been completed;

elevator means for transferring objects from said fixture unload position to a staging position adjacent to said transporter means; and

second handler means disposed adjacent to said staging position for transferring said objects from the said staging position to said transporter means;

object unloading means for unloading said objects from said exit region of said transporter means; and

control means coupled to said first handler means, said buffer storage means, said fixture means, said elevator means, and said second handler means of each of said processing stations for controlling the flow of objects through said system and through each processing station by directing said first handler means of each of said processing stations to selectively off-load objects from said transporter means to said buffer storage means of that processing station, by directing said buffer storage means to selectively release said objects onto said fixture means and by directing said elevator means and said second handler means to replace said objects onto said transporter means.

28. A processing system as in claim 27 wherein said transporter means comprises a plurality of transporter sections, each of said transporter sections being associated with one of said processing stations, said transporter sections are supported at an elevated position and are positioned proximate each other along the directions of travel such that each successive transporter section is operable for receiving objects from a preceding transporter section and for conveying objects to a succeeding transporter section.

29. A processing system as in claim 28 wherein the transporter means is operable for intermittent movement wherein the objects upon said transporter means are conveyed along the direction of travel by an equal distance during periods of movement of said transporter means and wherein said objects are off-loaded from and replaced upon said transporter means by the first and second handler means of the several processing stations during periods of no movement of said transporter means.

30. A processing systems as in claim 27 wherein said control means additionally comprises sensors, coupled to said buffer storage means, for sensing when any of said buffer storage means are full, and wherein said control means is additionally coupled to said object loading means and is operable for directing said object loading means to load such objects onto said transporter means that do not require processing operations to be performed by the processing means associated with any processing stations having full buffer storage means.

31. An object transporter apparatus for automatically transporting objects to and from processing means, wherein said processing means performs processing operations upon said objects, and wherein said objects are planar and uniform in size and have two longitudinal edges, said apparatus comprising:
transporter means for unidirectionally conveying said objects, said transporter means comprising two spaced apart belts forming an open area therebetween, said belts are operable for contacting said objects proximate to said longitudinal edges thereof, said transporter means also comprising belt drive means for driving said belts in a recirculating fashion;
first handler means disposed adjacent to said transporter means for off-loading said objects from said transporter means, said first handler means is operable for off-loading said objects by grasping and lifting said objects from said belts, then tilting said objects and lowering them through the open area between said belts, then releasing said objects at a point below said transporter means;
buffer storage means disposed below said first handler means for temporary storage of a stack of one or more of said objects, said buffer storage means comprising a plurality of roller means that are operable for

41

**0135117**

receiving objects from said first handler means and placing said objects onto the top of said stack, and for spacing apart said objects of said stack, and also comprising release means for selectively releasing objects from the bottom of said stack;

fixture means disposed below said buffer storage means for receiving objects from said buffer storage means, for positioning said objects within said processing means to permit said processing means to perform said processing operations upon said objects, and for positioning said objects at a fixture unload position away from said buffer storage means and said processing means after said processing operations have been completed;

elevator means for transferring said objects from said fixture unload position to a staging position adjacent to said transporter means;

second handler means disposed adjacent to said staging position for transferring said objects from said staging position to said transporter means, said second handler means is operable for transferring said objects by grasping and tilting said objects, then lifting said objects through the open area between the belts, then leveling said objects and placing them upon said belts, then releasing said objects; and control means coupled to said first handler means, said buffer storage means, said fixture means, said elevator means, and said second handler means for controlling the flow of said objects through said apparatus by directing said first handler means to off-load said objects from said transporter means to said buffer storage means, by directing said buffer storage means to release said objects onto said fixture means, and by directing said elevator means and said second handler means to replace said objects onto said transporter means.

32. A processing system for automatically performing processing operations upon objects, each of said processing operations being performed on each of said objects by one or more of a plurality of processing means, said objects are planar and uniform in size and have two longitudinal edges, said system comprising: transporter means for unidirectionally conveying said objects, said transporter means comprising two spaced apart belts forming an opean area therebetween, said belts are operable for contracting said objects proximate to said longitudinal edges thereof, said transporter means also comprising belt drive means for driving said belts in a recirculating fashion; object loading means for loading said objects onto an entrance region of said transporter means; a plurality of processing stations disposed along the length of said transporter means, each of said processing stations is operable for selectively transporting said objects to and from one of said processing means, each of said processing stations comprising: first handler disposed adjacent to said transporter means for off-loading, from said transporter means, objects to be processed by the processing means associated with said processing station, said first handler means is operable for off-loading said objects by grasping and lifting said objects from said belts, then tilting said objects and lowering them through the open area between said belts, then releasing said objects at a point below said transporter means; buffer storage means disposed below said first handler means for temporary storage of a stack of one or more of said objects, said buffer storage means comprising a plurality of roller means that are operable for receiving said objects from said first handler means and placing said objects onto the top of said stack, and for spacing apart said objects of said stack, and also comprising release means for selectively releasing said objects from the bottom of said stack;
fixture means disposed below said buffer storage means for receiving said objects released from said buffer storage means, for positioning said objects within said processing means to permit said processing means to perform said processing operations upon said objects, and for positioning said objects at a fixture unload position away from said buffer storage means and said processing means after said processing operations have been completed;
elevator means for transferring said objects from said fixture unload position to a staging position adjacent to said transporter means; and
second handler means disposed adjacent to said staging position for transferring said objects from said staging position to said transporter means, said second handler means is operable for transferring said objects by grasping and tilting said objects, then lifting said objefts through the open area between the belts, then leveling said objects and placing them upon said belts, then releasing said objects;
object unloading means for unloading said objects from an exit region of said transporter means; and control means coupled to said first handler means, said buffer storage means, said fixture means, said elevator means, and said second handler means of each of said processing stations for controlling the flow of objects through said system and through each processing station by directing said first handler means of each of said processing stations to selectively off-load said objects from said transporter means to said buffer storage means of that processing station, by directing said buffer storage means to selectively release said objects onto said fixture means, and by directing said elevator means and said second handler means to replace said objects onto said transporter means.

44                    0135117

33. An object handler apparatus for loading and unloading a planar object onto and from two spaced apart conveyor belts having an open area therebetween, said objects having two longitudinal edges disposed parallel to the direction of travel of said belts and two transverse edges disposed substantially perpendicular to said direction of travel, said apparatus comprising:

support means for supporting said apparatus above said conveyor belts;

moveable plate means slideably coupled to said support means for vertical travel between an upper position and a lower position;

object grasping means coupled to said moveable plate means for grasping, tilting, and releasing said object; and

first actuator means affixed to said support means and coupled to said moveable plate means for moving said moveable plate means between said upper and lower positions.

34. An apparatus as in claim 33 wherein said moveable plate means comprises:

an upper plate disposed above said support means;

a lower plate disposed below said support means and fixedly coupled to said upper plate; and

guide means affixed to said upper and lower plates and slideably coupled to said support means for guiding said upper and lower plates between the upper position and the lower position;

and wherein the first actuator means includes a first actuator rod that extends downwardly from said first actuator means and is coupled at the lower end thereof to said lower plate, said first actuator means is operable for moving said first actuator rod between a retracted position where said moveable plate means is at said upper position and an extended position where said moveable plate means is at said lower position.

**0135117**

35. An apparatus as in claim 34 wherein said guide means comprises two vertical guide shafts disposed between and affixed to the upper and lower plates and two corresponding bushings affixed to the support means and slideably coupled to said guide shafts, said bushings are operable for guiding said guide shafts as said moveable plate means moves between the upper and lower positions, said guide means also comprises a plurality of rollers rotatably coupled to said upper plate and disposed in rolling contact with said first actuator means, said rollers are operable for guiding said upper plate as said moveable plate means moves between said upper and lower positions.

36. An apparatus as in claim 34 wherein said object grasping means comprises:
   second and third actuator rods disposed vertically and slideably coupled to the moveable plate means, said second and third actuator rods are spaced apart by a distance greater than the longitudinal length of the object;
   second and third actuator means affixed to the upper plate for extending, rotating, and retracing said second and third actuator rods, respectively, said second and third actuator means are operable for extending said second and third actuator rods into the open area between the conveyor belts when said moveable plate means is at the upper position;
   two lift pins, each affixed to the lower end of one of said second and third actuator rods and oriented at substantially right angles to the axes thereof;
   two pivot levers, each disposed proximate one of said second and third actuator rods and pivotably coupled at one end thereof to said lower plate;
   two clamping brackets, each pivotably coupled to the other end of said pivot levers and slideably coupled to one of said second and third actuator rods at a position above said lift pins; and

biasing means for biasing said clamping brackets toward said lift pins.

37. An apparatus as in claim 36 wherein said apparatus is operable for unloading objects from the conveyor belts by grasping and lifting said objects from the belts, then tilting said objects and lowering them through the open area between said belts, then releasing said objects at a point below said transporter means.

38. An apparatus as in claim 37 wherein said apparatus is operable for loading objects onto the conveyor belts from a position below said conveyor belts by grasping and tilting said objects, then lifting said objects through the open area between the belts of said transporter means, then leveling said objects and placing them upon said belts, then releasing said objects.

39. An apparatus as in claim 38 wherein said object grasping means is operable for grasping one of the objects by extending said second and third actuator rods, with said lift pins pointing transversely, until said clamping brackets are resting upon the upper surface of the object and said lift pins are below said object, then rotating said second and third actuator rods until said lift pins point toward each other, then retracting said second and third actuator rods to lift said lift pins against said object; and wherein said object grasping means is operable for tilting said object by continuing to retract said second and third actuator rods, thereby causing said pivot levers to pivot about their respective pivotable couplings and causing said clamping brackets and said object to tilt; and wherein said object grasping means is operable for releasing said object by rotating said second and third

47                                    0135117

actuator rods until said lift pins are no longer
below said object.

40. An apparatus as in claim 39 wherein said object
    grasping means is operable for lifting objects by
    retracting the second and third actuator rods, said
    apparatus is also operable for lifting said objects
    by moving the moveable plate means to the upper
    position, and for lowering said objects by moving
    the moveable plate means to the lower position.

41. An apparatus as in claim 39 wherein said apparatus
    further comprises support raising means disposed
    between the support means and the conveyor belts for
    lifting objects from said conveyor belts by raising
    said support means.

42. A buffer storage apparatus for the temporary storage
    of objects, said objects are planar and uniform in
    size and have two longitudinal edges, said apparatus
    comprising:
    a frame;
    a plurality of roller means, pivotably coupled to
    said frame, for spacing apart said objects in a stack,
    said roller means are operable for receiving and
    placing objects upon the top of said stack; and
    release means for releasing the bottom-most object
    of said stack.

43. An apparatus as in claim 42 wherein each of said
    plurality of roller means comprises:
    two axles rotatably coupled to said frame, said two
    axles are parallel and lie in a horizontal plane and
    are spaced apart by a distance greater than the
    distance between the two longitudinal edges of the
    objects;
    star wheels affixed to and rotatable with said axles, one of said axles having at least two star wheels affixed thereto and the other of said axles having at least one star wheel affixed thereto, each of said star wheels having a plurality of uniformly spaced apart spokes protruding radially therefrom, said spokes are operable for contacting said longitudinal edges of one of said objects; and interconnection means for coupling the rotations of said two axles such that two axles counter-rotate by an equal amount; and wherein said plurality of roller means are positioned such that said axles of said plurality of roller means lie in two vertical and parallel planes, said axles are vertically spaced apart such that said star wheels of an upper one of said roller means are prevented from rotating by the presence of one of said objects supported by a lower one of said roller means.

44. An apparatus as in claim 43 wherein said interconnection means for each roller means comprises two pulleys, each affixed to and rotatable with one of the axles, and a belt coupled to said pulley and disposed in a figure eight pattern therebetween.

45. An apparatus as in claim 43 wherein said said buffer storage means is operable for forming the stack of objects by preventing the axles of the bottom-most roller means from rotating, thereby retaining a bottom-most object with the star wheels of said bottom-most roller means, and wherein said buffer storage means is operable for releasing said bottom-most object by allowing said axles of said bottom-most roller means to rotate by an amount sufficient to permit said bottom-most object to drop.

46. An apparatus as in claim 45 wherein said star wheels have six uniformly spaced apart spokes protruding radially therefrom, and wherein said release means is operable for allowing the axles of the bottom-most roller means to rotate by one-sixth of a revolution.

47. An apparatus as in claim 46 wherein said release means comprises:
a three sided cam affixed to and rotatable with one of the axles of the bottom-most roller means;
a release frame disposed proximate said cam;
two cam rollers coupled to said frame, one of said cam rollers is disposed above said cam and the other one of said cam rollers is disposed below said cam; and
release actuator means coupled to said frame and operable for reciprocally moving said release frame to alternately bring each of said cam rollers into contact with said cam, wherein said cam rotates by one-sixth of a revolution upon each such contact.

48. A method of transporting objects to and from processing means, said objects are planar and uniform in shape, said method comprising the steps of:
placing said objects, one at a time; onto two spaced apart belts of a transporter, said transporter is operable for moving said objects by driving said belts;
advancing said objects by a uniform distance and then stopping;
unloading a first object from said transporter by first grasping and lifting said first object, then tilting said first object, then lowering said first object through an open area between said belts, then releasing said first object into a buffer storage unit having roller means, wherein said roller means are operable for guiding the descent of said first object onto the top of a stack of objects and are also operable for spacing apart the objects within said stack;

releasing a second object from the bottom of said stack onto alignment pins of a fixture positioned below said buffer storage unit;

aligning and clamping said second object to said fixture as said fixture moves said second object to said processing means;

releasing said second object from said fixture as said fixture moves said second object away from said processing means and to a fixture unload position;

raising said second object to a staging position directly under said transporter;

replacing said second object onto said transporter by first grasping and tilting said second object, then raising said second object through said open area between said belts, then leveling said second object and lowering it onto said belts, then releasing said second object.

49. The method according to claim 48 wherein said step of unloading a first object from the transporter comprises the steps of:

positioning said object below a board depositor handler, said board depositor handler having first, second, and third actuator means, each of said actuator means is operable for extending and retracting respective first, second, and third actuator rods, said second and third actuator rods having clamping brackets pivotably coupled thereto, said board depositor handler having all of said actuator rods positioned in their retracted positions;

extending said second and third actuator rods into the open area between the belts until the lower ends of said second and third actuator rods are adjacent to and below two opposite sides of said object and said clamping brackets are contacting the upper surface of said object;

rotating said second and third actuator rods about their respective axes until lift pins affixed thereto are positioned below said object;
retracting said second and third actuator rods to grasp said object;
continuing retracting said second and third actuator rods to lift and tilt said object by causing said clamping brackets to tilt;
extending said first actuator rod to lower said object through said open area between the belts;
extending said second and third actuator rods to level said object;
rotating said second and third actuator rods about their respective axes until said lift pins are no longer below said object, thereby releasing said object; and
retracting said first, second and third actuator rods.

50. The method according to claim 48 wherein the step of unloading the second object from the transporter comprises the steps of:
positioning said object below a board depositor handler, said board depositor handler having first, second, third, and fourth actuator means, said first, second, and third actuator means are operable for extending and retracting respective first, second, and third actuator rods, said first actuator means is operable for raising and lowering said second and third actuator means, said fourth actuator means is operable for raising and lowering said board depositor handler, said second and third actuator rods having clamping brackets pivotably coupled thereto, said board depositor handler having said first actuator rod positioned in its retracted position and said second and third actuator rods positioned in their extended positions;
lowering said board depositor handler such that said second and third actuator rods extend into the open area between the belts until the lower ends of said second and third actuator rods are adjacent to and below two opposite sides of said object and said clamping brackets are contacting the upper surface of said object;

rotating said second and third actuator rods about their respective axes until lift pins affixed thereto are positioned below said object;

retracting said second and third actuator rods to grasp said object;

continuing retracting said second and third actuator rods to lift and tilt said object by causing said clamping brackets to tilt, while also raising said board depositor handler;

extending said first actuator rod to lower said object through said open area between the belts;

extending said second and third actuator rods to level said object;

rotating said second and third actuator rods about their respective axes until said lift pins are no longer below said object, thereby releasing said object; and retracting said first, second, and third actuator rods to provide clearance between the lower ends of said second and third actuator rods and said transporter.

51. The method according to claim 48 wherein the step of replacing the second object onto the transporter comprises the steps of:

positioning said object below said transporter and below a board retriever handler, said board retriever handler having first, second. and third actuator means, each of said actuator means is operable for extending and retracting respective first, second, and third actuator rods, said second and third actuator rods having clamping bracke-s pivotably coupled thereto, said board depositor handler having all of said

0135117

actuator rods positioned in their retracted positions; extending said first, second, and third actuator rods such that said second and third actuator rods extend into the open area between the belts until the lower ends of said second and third actuator rods are adjacent to and below two opposite sides of said object and said clamping brackets are contacting the upper surface of said object;
rotating said second and third actuator rods about their respective axes until lift pins affixed thereto are positioned below said object;
retracting said second and third actuator rods to grasp said object;
continuing retracting said second and third actuator rods to lift and tilt said object by causing said clamping brackets to tilt;
retracting said first actuator rod to lift said object through said open area between the belts;
extending said second and third actuator rods to level and lower said object;
rotating said second and third actuator rods about their respective axes until said lift pins are no longer below said object, thereby releasing said object onto said transporter; and
retracting said second and third actuator rods.

52. The method according to claim 48 wherein the step of replacing the second object onto the transporter comprises the steps of:
positioning said object below said transporter and below a board retriever handler, said board retriever handler having first, second, third and fourth actuator means, said first, second, and third actuator means are operable for extending and retracting respective first, second, and third actuator rods, said first actuator means is operable for raising and lowering said second and third actuator means, said fourth actuator means is operable for raising and lowering said board retriever handler, said second and third actuator rods having clamping brackets pivotably coupled thereto, said board depositor handler having said first actuator rod positioned in its retracted position and said second and third actuator rods positioned in their extended positions;

extending said first actuator rod such that said second and third actuator rods extend into the open area between the belts until the lower ends of said second and third actuator rods are adjacent to and below two opposite sides of said object and said clamping brackets are contacting the upper surface of said object;

rotating said second and third actuator rods about their respective axes until lift pins affixed thereto are positioned below said object;

retracting said second and third actuator rods to grasp said object;

continuing retracting said second and third actuator rods to lift and tilt said object by causing said clamping brackets to tilt;

retracting said first actuator rod to lift said object through said open area between the belts;

extending said second and third actuator rods to level said object;

lowering said board retriever handler to lower said object onto said transporter;

rotating said second and third actuator rods about their respective axes until said lift pins are no longer below said object, thereby releasing said object onto said transporter; and

raising said board retriever handler to provide clearance between the lower ends of said second and third actuator rods and said transporter.

53. The method according to claim 48 wherein the step

55      **0135117**

of releasing the second object onto alignment pins of the fixture includes supporting said object upon support surfaces of clamping cams, said clamping cams being in a released position;

and wherein the step of aligning and clamping said second object to said fixture includes lowering said object onto said alignment pins by rotating said clamping cams to a clamped position.

FIG. 1

0135117

FIG. 2

FIG. 3

**FIG. 3**

- 24 (dashed box boundary)
- 26 (dashed box, right)

Blocks:
- Transporter Drive Motor — 84
- Board Depositor Actuator — 88
- Loader Actuator — 80
- Bar Code Reader — 86
- Buffer Full Sensor — 90
- System Controller — 40
- Unloader Sensor & Actuator — 82
- Fixture Position Sensor — 92
- Board Retriever Actuator — 98
- Buffer Release Actuator — 94
- Elevator Actuator — 96

3/12

0135117

FIG. 4

FIG. 5

FIG. 6a

FIG. 6b

FIG.6c

FIG.6d

FIG.6e

7/12

0135117

228 — 222

224 68

210 212
218 220

FIG.7a

FIG.7b

400

398

402 404

396

394

FIG.15

236

FIG. 8

0135117

FIG.9a

FIG.9b

FIG.9c

FIG.9d

FIG.9e

FIG.10

FIG. 11

FIG. 12a

FIG. 12b

0135117

FIG. 13

FIG. 14